# EUROPEAN PATENT APPLICATION

(11) **EP 3 633 396 A1**
(43) Date of publication of application: **08.04.2020**
(21) Application number: 19753734.3
(22) Date of filing: 09.02.2019
(51) Int. Cl.: G01R 31/08, B64C 39/02

(54) **METHOD OF GRIPPING AN ELECTRICAL TRANSMISSION LINE FOR REMOTE MONITORING**

(30) Priority: 19.02.2018 RU 2018106097
(71) Applicant: Obshchestov S Ogranichennoy Otvetstvennostyu "Laboratoriya Budushchego" (OOO "Laboratoriya Budushchego"), Ekaterinburg, 620109 (RU)
(72) Inventor: SHASTIN, Arnold Georgievich, Zarechnyy, 624250 (RU); LEMEKH, Aleksandr Viktorovich, Ekaterinburg, 620109 (RU)
(74) Representative: Spengler, Robert
(86) International application number: PCT/RU2019/050015
(87) International publication number: WO 2019/160453

(57) **Abstract**

The invention relates to unmanned aircrafts for monitoring state of or conducting repair work on power transmission lines. The method of grasping a power transmission line conductor by an operating member of an execution unit of an apparatus for remote monitoring equipped with a flying-lifting facility for being carried to a worksite includes: using, on takeoff, a lifting force of the flying-lifting facility to open a magnetic head, and using, on landing on the conductor, a gravitational force of the flying-lifting facility to close the magnetic head, wherein the forces influence the opening-closing motion due to movements of the flying-lifting facility relative to the execution unit. The apparatus includes a flying-lifting facility, an execution unit comprising a means for moving along a wire, and an operating member, for example, a magnetic head of a magnetic flaw detector, a system of rods and levers, and a sleeve slidably seated on a guide of the execution unit such.

## Description

The invention relates to aircraft engineering and, in particular, to helicopter-type unmanned aircrafts included in robotic and remote controlled complexes designed for performing various kinds of operation in difficult-to-access or health-dangerous conditions, for example, for monitoring state of or conducting repair work on power transmission lines, in places with high background of radioactive emissions, etc.

In all such cases, a flying-lifting facility, more precisely, the motors of the flying-lifting facility are used only for moving in space with change of movement height, direction and speed. At the same time, the movement in space may only be performed from point A to point B (conveying of load) [1], or with execution of any actions during the flight associated with change of flight altitude, speed and direction, for example, for video surveillance and radiation survey of a territory [2]. The movement control may be either software, interactive, or manual (with push-buttons) and performed from a control panel.

In some cases, during operation, it is necessary to land on different objects where the execution device carried by the flying-lifting facility performs required actions associated with specific task. Meanwhile, the flying-lifting facility and the execution unit are connected to each other and are integral, and the execution unit comprises all operating members required for performing the task, including power drives for these members. An example of such devices may be a device for diagnostic of overhead power transmission lines (OPTL) [3]. In this device (taken as a prototype), the flying-lifting facility carries the execution unit to a worksite (on the lightning-protective wire of the OPTL) and settles it on the wire. Then execution unit performs its task related to monitoring process of state of the wire by moving from one tower of the OPLT to another. After that, the flying-lifting device takes off and transfers the execution unit over the tower to monitor a next wire, etc.

The operating member performing the monitor and diagnostic operation in the execution unit of the device for diagnostics of the overhead power transmission line may be, for example, a magnetic head of a magnetic flaw detector which, when settled on the wire, has to open and then to close, for performing the monitoring, by embracing the wire. Then, moving along the wire to the next tower, it has to monitor state of the wire. At the end of the monitoring, the head has to open, so that the flying-lifting facility is able to remove the execution unit from the wire and transfer it to other side of the tower.

In order the magnetic head be opened and closed, it is typically equipped with a special electric drive. The presence of the electric drive for opening-closing the magnetic head not only complicates a design of the device as a whole, but also increases probability of failure during its operation. In case of failure of electric drive with the closed magnetic head, the flying-lifting facility would not be able to remove the execution unit from the wire. In such a case, it would be necessary to carry out rather labor intensive and long-term operations including necessary disabling the OPTL to open or repair the opening drive at the height of the magnetic head to remove the entire device from the wire.

Object of the present invention is to simplify the design, increase reliability and safety of operation of robotic and remote-controlled complexes including helicopter-type flying-lifting facilities.

The above object is achieved by that in order to actuate the operating members of the execution units, the propelling force of the motors or the gravitational force of the flying-lifting facility which occur at takeoff or landing, respectively, are used.

The essence of the method is explained by an apparatus for remote monitoring a lightning-protection wire of a power transmission line represented in the Figures 1-4, where:
Figure 1 shows a longitudinal section of the apparatus;
Figure 2 shows the apparatus for remote performing operations in initial state "on earth"
Figure 3 shows the apparatus for remote performing operations "in flight";
Figure 4 shows the apparatus for remote performing operations "on wire"

### Embodiment of the Invention

The apparatus consists of a flying-lifting facility with motors 1 mounted on a frame 2 provided with a sleeve 3. The sleeve 3 is movably seated on a guide 4 mounted on an execution unit 5. Axis of the sleeve coincides with a vertical line passing through the center of mass of the execution unit. Adjustable upper and lower stop members are installed at the top and at the base of the guide 4, respectively. The execution unit 5 is provided with an operating member 8 - a magnetic head of a magnetic flaw detector, the head made as a cylinder (yoke) consisting of two half-cylinders interconnected by an axle 9.

The half-cylinders of the magnetic head are connected by means of rods 10 and bell-crank levers 11 to the frame 2 of the flying-lifting facility.

In addition, the execution unit 5 is provided with supports 12 and wheeled transportation facility 13 for moving it along a wire 14.

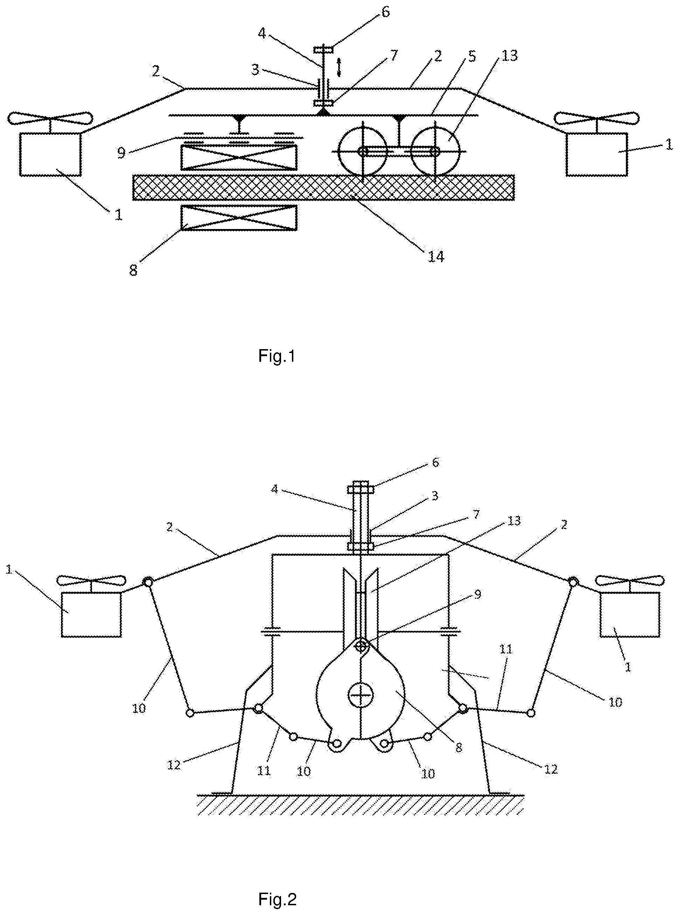

In the initial position "on earth" (FIG. 1), the execution unit 5 stands "on earth" (FIG. 1) by resting on the supports 12. The sleeve 3 together with the frame 2 of the flying-lifting facility under the action of gravitational force are in the lower position at the adjustable stop member 7. The yoke of the magnetic head 8 (operating member) is in the closed position.

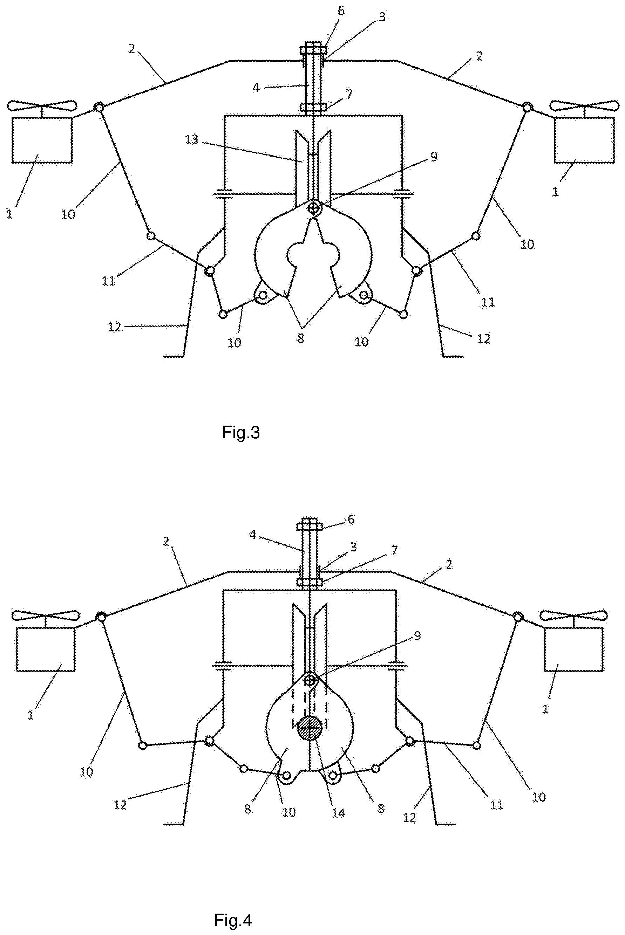

When the motors 1 of the flying-lifting facility are powered on, the frame 2 together with the sleeve 3 begins to rise upward along the guide 4 to the adjustable upper stop member 6. When the frame 2 is moved upward, the rods 10 and the levers 11 open the magnetic head 8. When the sleeve 3 abuts against the adjustable upper stop member 6, a process of lifting and carrying the execution unit 5 to the lightning-protection wire 14 begins (FIG. 3).

While landing on the wire 14 (FIG. 4), the opened magnetic head 8 is moved downward, the wire enters the head until the wire abuts against the head upper part with a narrow opening (less than the diameter of the wire). At the same time, the wheels of the transportation facility 13 rest on the wire 14, the execution unit 5 stops to move down and the flying-lifting facility continues to move down under the action of gravitational force, the magnetic head is being closed (rolling forces of the half-cylinders), and the sleeve 3 reaches the lower stop member 7. The execution unit 5 is ready to perform monitoring of the wire 14. Upon completion of the monitoring performed by moving the magnetic head 8 along the entire length of the wire 14 by wheeled transportation facility 13, the motors of the flying-lifting facility are powered on. At this time, the flying-lifting facility starts to rise (the sleeve 3 slides along the guide 4), and rods 10 and levers 11 open the magnetic head 8. The sleeve 3 abuts against the upper adjustable stop member 6 and lifting of the execution unit 5 is started for repositioning it into a new worksite.

In case any failure occurs, for example, even if power supplying of the motor of the flying-lifting facility fails, the apparatus may be easily removed from the lightning-protection wire by lifting it upwards by the frame 2 of the flying-lifting facility.

According to the present method and apparatus for performing thereof, in order to open the operating member of the apparatus for remote performing operations, the lifting force of the motors of the flying-lifting facility at takeoff is used, and when landing in order to close the execution member, the gravitational force the facility is used, which influences the operating member by means of movement of the flying-lifting facility and execution unit relative to each other.

The advantages of the present method and the apparatus for performing thereof are:
- the simplified design;
- the improved reliability of operation;
- the increased safety of operation.

### Citation list

### Patent Literature

patcit 1: Specification of invention to the Patent RU 2390468.
patcit 2: Specification of invention to the Patent RU 2223803.
patcit 3: Specification of invention to the Patent RU25580021.

## Claims

1. Method for grasping a power transmission line conductor by an operating member of an execution unit of an apparatus for remote monitoring equipped with a flying-lifting facility for being carried to a worksite, **characterized by**
using, on takeoff, a lifting force of the flying-lifting facility to open the operating member - a magnetic head, and
using, on landing on the conductor, a gravitational force of the flying-lifting facility to close the magnetic head,
wherein the forces influence the opening-closing motion due to movements of the flying-lifting facility relative to the execution unit.

2. Apparatus for remote monitoring power transmission lines, the apparatus including a flying-lifting facility, an execution unit comprising a facility for moving along a wire and an operating member - a magnetic head of a magnetic flaw detector, **characterized in that**
the flying-lifting facility is provided with a system of rods and levers connected with the magnetic head, and a sleeve slidably seated on a guide of the execution unit, wherein the guide is provided in its upper part and at its base with adjustable stop members - travel limiters of the flying-lifting facility relative to the execution unit, and the axis of the guide coincides with a vertical line passing through the centre of mass of the execution unit.
